# EUROPÄISCHE PATENTSCHRIFT

(11) **EP 0 974 847 B1**
(45) Veröffentlichungstag und Bekanntmachung des Hinweises auf die Patenterteilung: **04.06.2003**
(21) Anmeldenummer: 99113053.5
(22) Anmeldetag: 01.07.1999
(51) Int. Cl.: G01R 31/3187, G06F 11/22, G06F 11/00, G11C 29/00

(54) **Anordnung und Verfahren zum Speichern der mit einer BIST-Schaltung erhaltenen Testergebnisse**
Arrangement and method to store the test results of a BIST-circuit
Dispositif et procédé pour stocker les resultats d'un test effectué par un circuit à auto-test

(30) Priorität: 14.07.1998 DE 19831572
(43) Veröffentlichungstag der Anmeldung: 26.01.2000
(73) Patentinhaber: Infineon Technologies AG, 81669 München (DE)
(72) Erfinder: Krasser, Hans-Jürgen, 81737 München (DE); Schamberger, Florian, 83435 Bad Reichenhall (DE)
(74) Vertreter: Müller - Hoffmann & Partner

(56) Entgegenhaltungen:
- EP-A- 0 831 401
- US-A- 5 568 437
- US-A- 5 644 578
- US-A- 5 659 551

## Beschreibung

Die Erfindung betrifft eine Anordnung und ein Verfahren zum Speichern der mit einer BIST-Schaltung erhaltenen Testergebnisse von einem eine Speichervorrichtung aufweisenden Halbleiterchip.

Integrierte Schaltungen und speziell Speichervorrichtungen, die in einem Halbleiterchip realisiert sind, werden bekanntlich mit Hilfe einer BIST-Schaltung (BIST = Built-In-Self-Test bzw. eingebaute Selbsttestschaltung) auf ihre Funktionsfähigkeit getestet. Die Ergebnisse, die bei solchen Untersuchungen mit Hilfe der im Halbleiterchip enthaltenen BIST-Schaltung erhalten werden, werden in einem zusätzlichen SRAM (statischer RAM) auf dem Halbleiterchip abgespeichert. Mit anderen Worten, bisher wird zusätzlich auf dem Halbleiterchip noch ein SRAM vorgesehen, um die von der BIST-Schaltung erhaltenen Testergebnisse abzuspeichern, bevor beispielsweise diese Ergebnisse vor Abschluß einer Testreihe ausgelesen werden.

Dieser zusätzliche SRAM benötigt Platz auf dem Speicherchip, der dann für andere Zwecke nicht genutzt werden kann. Auch ein externes Abspeichern der Testergebnisse ist wenig hilfreich, da ein solches mit zusätzlichem Aufwand verbunden ist, der schon darin begründet liegt, daß externe SRAMs gesondert kontaktiert und angeschlossen werden müssen.

In der US 5,568,437 ist eine Anordnung mit einem RAM und einer BIST-Schaltung beschrieben; bei dieser Anordnung werden die Adressen von fehlerhaften Speicherzellen des RAMs in einem gesonderten BIST-Register abgelegt.

Es ist Aufgabe der vorliegenden Erfindung, eine Anordnung und ein Verfahren zum Speichern der von einer BIST-Schaltung erhaltenen Testergebnisse zu schaffen, mit denen diese Testergebnisse ohne zusätzlichen Flächenbedarf oder externe Speichervorrichtungen abspeicherbar sind.

Diese Aufgabe wird bei einer Anordnung und einem Verfahren der eingangs genannten Art erfindungsgemäß dadurch gelöst, daß die Testergebnisse in Leseverstärkern der Speichervorrichtung selbst abspeicherbar sind bzw. dort abgespeichert werden. Auch Testprogramme für die BIST-Schaltung können in diesen Leseverstärkern abgelegt werden.

Mit anderen Worten, die vorliegende Erfindung verwendet die ohnehin vorhandenen Leseverstärker einer in einem Halbleiterchip realisierten Speichervorrichtung zum Speichern der Testergebnisse von BIST-Schaltungen.

Damit geht die Erfindung einen vom bisherigen Stand der Technik vollkommen abweichenden Weg: anstelle eines SRAMs, der im Halbleiterchip selbst oder auch extern realisiert sein kann, werden die Leseverstärker der im Halbleiterchip vorgesehenen Speichervorrichtung zum Abspeichern der Testergebnisse der BIST-Schaltung herangezogen. Damit kann eine nicht unerhebliche Flächeneinsparung erhalten werden: für das Abspeichern der Testergebnisse der BIST-Schaltung werden nämlich keine zusätzlichen SRAMs benötigt. Vielmehr werden die Testergebnisse in den bereits vorhandenen Leseverstärkern abgespeichert, so daß damit eine flächenneutrale Gestaltung einer Speichervorrichtung möglich ist. Es ist nämlich überhaupt kein zusätzlicher Aufwand erforderlich, um diese Meßergebnisse abspeichern zu können.

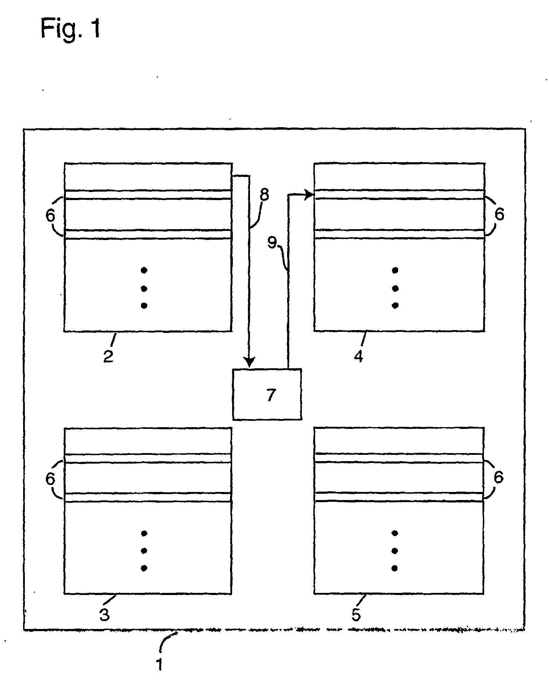

Nachfolgend wird die Erfindung anhand der Zeichnung näher erläutert, in deren einziger Figur ein Blockschaltbild der erfindungsgemäßen Anordnung gezeigt ist.

Ein Halbleiterchip 1 enthält beispielsweise vier Speicherzellenfelder 2, 3, 4, 5, die jeweils mit mehreren Leseverstärkerreihen 6 versehen sind. Die Speicherzellenfelder werden durch eine BIST-Schaltung 7 auf ihre Funktionsfähigkeit getestet, wie dies durch einen Pfeil 8 veranschaulicht ist.

Bisher werden die bei diesem Test erhaltenen Meßergebnisse der BIST-Schaltung 7 in einem gesonderten SRAM abgespeichert, der bzw. das entweder auf dem Halbleiterchip 1 selbst vorgesehen oder extern zu diesem angeordnet ist.

Bei der erfindungsgemäßen Anordnung bzw. bei dem erfindungsgemäßen Verfahren ist ein solcher gesonderter SRAM zum Abspeichern der Testergebnisse der BIST-Schaltung 7 nicht erforderlich. Vielmehr werden diese Testergebnisse in einem Leseverstärker 6 eines Speicherzellenfeldes, im vorliegenden Fall beispielsweise des Speicherzellenfeldes 4, abgespeichert, um dann nach Abschluß der Testreihe ausgelesen zu werden. Dies ist von besonderem Vorteil, wenn die Daten der Testergebnisse auf dem Halbleiterchip 1 weiterverarbeitet werden, wobei Speicherknoten als Zwischenspeicher oder Register dienen.

Bei der erfindungsgemäßen Anordnung bzw. bei dem erfindungsgemäßen Verfahren wird somit kein zusätzlicher Platz auf dem Halbleiterchip 1 benötigt, um die von der BIST-Schaltung erhaltenen Meßergebnisse speichen zu können. Vielmehr werden diese Meßergebnisse in Abweichung vom bisherigen Stand der Technik in den Leseverstärkern eines Speicherzellenfeldes abgelegt, das gerade von der BIST-Schaltung nicht getestet wird. Nach Abschluß des Testens des betreffenden Speicherzellenfeldes kann der die Testergebnisse speichernde Leseverstärker eines anderen Speicherzellenfeldes ausgelesen werden.

Damit wird eine vollkommen flächenneutrale Lösung des oben aufgezeigten Problems gefunden: zusätzliche SRAMs werden nicht benötigt, vielmehr können die Meßergebnisse mit Hilfe der bestehenden Möglichkeiten abgespeichert werden.

## Patentansprüche

1. Anordnung zum Speichern der mit einer BIST-Schaltung (7) erhaltenen Testergebnisse von einem eine Speichervorrichtung (2, 3, 4, 5) aufweisenden Halbleiterchip (1),
**dadurch gekennzeichnet,**
**daß** die Testergebnisse in Leseverstärkern (6) der Speichervorrichtung selbst abspeicherbar sind.

2. Anordnung nach Anspruch 1,
**dadurch gekennzeichnet,**
**daß** Testprogramme für die BIST-Schaltung (7) in den Leseverstärkern (6) speicherbar sind.

3. Verfahren zum Speichern der mit einer BIST-Schaltung (7) erhaltenen Testergebnisse von einem eine Speichervorrichtung (2, 3, 4, 5) aufweisenden Halbleiterchip (1),
**dadurch gekennzeichnet,**
**daß** die Testergebnisse in Leseverstärkern (6) der Speichervorrichtung (2, 3, 4, 5) abgespeichert werden.

4. Verfahren nach Anspruch 3,
**dadurch gekennzeichnet,**
**daß** Testprogramme für die BIST-schaltung (6() in den Leseverstärkern gespeichert werden.

## Claims

1. Arrangement for storing the test results of a semiconductor chip (1) having a memory device (2, 3, 4, 5), the said test results being obtained by a BIST circuit (7),
**characterized**
**in that** the test results can be stored in sense amplifiers (6) of the memory device itself.

2. Arrangement according to Claim 1,
**characterized**
**in that** test programs for the BIST circuit (7) can be stored in the sense amplifiers (6).

3. Method for storing the test results of a semiconductor chip (1) having a memory device (2, 3, 4, 5), the said test results being obtained by a BIST circuit (7),
**characterized**
**in that** the test results are stored in sense amplifiers (6) of the memory device (2, 3, 4, 5).

4. Method according to Claim 3,
**characterized**
**in that** test programs for the BIST circuit (6() [sic] are stored in the sense amplifiers.

## Revendications

1. Dispositif de mémorisation des résultats de test obtenus par un circuit (7) BIST, d'une puce (1) à semiconducteur ayant un dispositif (2, 3, 4, 5) de mémoire,
**caractérisé en ce que** les résultats de test peuvent être mémorisés dans des amplificateurs (6) de lecture du dispositif de mémoire eux-mêmes.

2. Dispositif suivant la revendication 1, **caractérisé en ce que** les programmes de test pour le circuit (7) BIST peuvent être mémorisés dans les amplificateurs (6) de lecture.

3. Procédé de mémorisation des résultats de test, obtenus par un circuit (7) BIST, d'une puce (1) à semiconducteur ayant un dispositif (2, 3, 4, 5) de mémoire, **caractérisé en ce que** l'on mémorise les résultats de test dans des amplificateurs (6) de lecture du dispositif (2, 3, 4, 5) de mémoire.

4. Procédé suivant la revendication 3, **caractérisé en ce qu'**on mémorise les programmes d'essai pour le circuit (6) BIST dans les amplificateurs de lecture.
